Europäisches Patentamt

European Patent Office

Office européen des brevets

(11) Publication number: **0 128 476**
**B1**

(12) **EUROPEAN PATENT SPECIFICATION**

(45) Date of publication of patent specification: **01.03.89**

(51) Int. Cl.⁴: **C 04 B 41/88, C 04 B 41/91**

(21) Application number: **84106251.6**

(22) Date of filing: **01.06.84**

(54) Metallization of ceramics.

(30) Priority: **09.06.83 US 502748**
**10.05.84 US 607874**

(43) Date of publication of application:
**19.12.84 Bulletin 84/51**

(45) Publication of the grant of the patent:
**01.03.89 Bulletin 89/09**

(84) Designated Contracting States:
**AT CH DE FR GB IT LI NL SE**

(56) References cited:
**DE-A-2 733 684**
**FR-A-2 116 376**
**GB-A-1 519 333**
**US-A-3 690 921**
**US-A-3 993 802**
**US-A-3 994 727**
**US-A-4 206 254**

**CHEMICAL ABSTRACTS, vol. 84, no. 4, 26th
January 1976, page 286, column 1, abstract no.
21441u, Columbus, Ohio, US; & JP - A - 49 128
917 (TOYOTA MOTOR CO., LTD.) 10-12-1974**

(73) Proprietor: **KOLLMORGEN TECHNOLOGIES
CORPORATION
66 Gatehouse Road
Stamford Connecticut 06902 (US)**

(72) Inventor: **De Luca, Michael Albert
1534 Clas Avenue
Holbrook, NY 11741 (US)**
Inventor: **McCormack, John F.
116 Millburn Lane
Roslyn Heights, NY 11577 (US)**

(74) Representative: **Königseder, geb. Egerer,
Claudia
Zugspitzstrasse 65
D-8104 Grainau (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to metallized ceramic articles and to a metallized conductor pattern directly and adherently bonded onto a surface of a ceramic substrate, and an improved process for producing same. More particularly, this invention relates to a metal deposit, e.g., a printed circuit pattern directly and adherently bonded onto a surface of a ceramic substrate, and an improved process for producing same employing material in solution to promote adsorption of a species suitable for rendering said surface receptive for metal deposition.

Metallized conductor patterns on ceramic substrates have been widely used in the electronic industry. For many years, ceramics have been metallized by high cost processes such as fused metal-glass pastes and thin film vacuum deposition techniques. Attempts to reproducibly make circuit patterns by direct electroless deposition have not been successful due to poor adhesion of the metal films to the substrate and non-reproducible and non-uniform surface coverage. Printed circuits on ceramics, including alumina, were described as early as 1947 in, e.g., "Printed Circuit Techniques" National Bureau of Standards, Circular 468 (1947) and National Bureau of Standards, Misc. Pub. 192 (1948). One type, known as a thin film circuit, consists of a thin film of metal deposited on a ceramic substrate by one of the vacuum plating techniques. In these techniques, a chromium or molybdenum film, having a thickness of about 0.02 µm, acts as a bonding agent for copper or gold layers. Photolithography is used to produce high resolution patterns made by etching away the thin metal film. Such conductive patterns may be electroplated up to, typically, 7 µm thick. Due to their high cost, thin film circuits have been limited to specialized applications such as high frequency applications and military applications where a high pattern resolution is vital.

Another type of printed circuit, known as thick film circuit, comprises a conductor pattern consisting of a metal and glass film fired on a ceramic substrate. Typically, the film has a thickness of about 15 µm. Thick film circuits have been widely used. Thick film conductors are produced by screen printing in a circuit pattern with a paste containing a conductive metal powder and a glass frit in an organic carrier. After printing, the ceramic parts are fired in a furnace to burn off the carrier and sinter the conductive metal particles and fuse the glass. These conductors are firmly bonded to the ceramic by the glass and thus components may be attached to the conductors by soldering, wire bonding and the like.

Conductors in thick film circuits have only 30 to 60 percent of the conductivity of the pure metal. There is, however, a need for the high conductivity of pure metal to provide interconnections for high speed logic circuits.

The minimum conductor width and the minimum space between conductors which can be obtained by screen printing and firing under special high quality procedures is 125 and 200 µm respectively. However, under normal production conditions, these minima are 200 and 250 µm, respectively. For ceramic circuits requiring higher interconnection density, i.e., higher connectivity, multilayer techniques are, therefore, used.

In the thick film multilayer process, a first layer of metal powder and glass frit is printed on a ceramic substrate and fired, typically at 850°C. Subsequently, an insulating dielectric layer is screened over the conductor pattern, leaving exposed only the points at which contact is to be made to the next layer of metallization. This dielectric pattern, also, is fired at, e.g., 850°C and this procedure repeated to form a second dielectric layer and free of pinholes. The next conductor pattern layer is printed and fired making contact to the conductors of the lower conductor layer, as necessary, through the openings left in the dielectric layers.

Typical thick film multilayer ceramic packages contain two to six layers of metallization, and eight layers of circuit patterns are not uncommon. For two layers the substrate will be printed four times and fired at 850°C for four times, for three layers seven times, and for four layers ten times.

By the process of the present invention, the connectivity of a three or four layer thick film multilayer ceramic circuit can be achieved by a two-sided, plated through hole, conductor pattern.

Attempts have been made in the past to directly bond pure metal conductors to ceramic substrates including alumina in order to achieve higher conductivity for ceramic based circuit patterns. (US—A—3 766 634 and US—A—3 744 120). Solid State Technology 18/5, 42 (1975) and US—A—3 994 430 disclose a method for bonding copper sheets to alumina by heating the copper in air to form an oxide film on its surface. The thus prepared copper sheet is bonded to alumina at a temperature between 1 065°C and 1 075°C in a nitrogen furnace. In order to obtain well adhered copper foil without blisters, (1) the copper foil must be carefully oxidized to a black surface, (2) the copper oxide thickness must be carefully controlled, (3) the amount of oxygen in the copper foil must be controlled, (4) the oxygen content of the nitrogen furnace must be maintained at a controlled level to maintain a very moderately oxidizing atmosphere, and (5) the temperature must be controlled within one percent. In spite of the difficult operating conditions, the process of US—A—3 994 430 is being introduced into commercial application because of the need for the metallized product.

Although the above described systems are commercially used, the need for direct, simple metallization of ceramics for producing pure metal conductors, such as copper, has prompted a continuous series of patents and proposed processes, as, e.g., DE—C—20 04 113, 24 53 192, 24 53 277 and 25 33 524. In US—A—3 296 012 is disclosed a method of producing a microporous surface for electrolessly plating alumina.

Attempts to simply apply electroless metallization directly to ceramic substrates have continually been tried and never been commercially successful. Even such toxic and corrosive materials as hydrogen fluoride were tried to allow the direct bonding of electroless metal to ceramics without extreme firing temperatures. Compare Ameen et al, J. Electrochem. Soc., 120, 1518 (1973). However, the hydrofluoric etch concept gave poor strength of the bond due to excessive attack on the surface of the ceramic.

Another attempt, disclosed in US—A—3 690 921, involved the use of molten sodium hydroxide to etch a ceramic surface. In this process, subsequently, sodium hydroxide is rinsed from the ceramic surface with water, the ceramic surface neutralized with dilute sulfuric acid and rinsed again before sensitizing with a stannous chloride solution, rinsing and seeding with a palladium chloride solution, to catalyze said surface for electroless metal plating.

Although a metal film deposit with good bond strength is achieved by this process, nonetheless, it did not reach acceptance for commercial production. The reason is poor surface coverage by the electrolessly deposited metal. Although the metal deposit usually covered 90% of the surface area or even more, this was unacceptable; any imperfection in the formed metal from may cause defective circuit conductors and a failure if such imperfection occurs in a fine line conductor pattern to a complete operating failure.

With prolonged immersion in both the stannous chloride sensitizer solution and the palladium chloride seeder solution as well as incomplete rinsing steps, it sometimes may be possible to achieve substantially complete surface coverage with metal. Such approach is, however, not practical for production purposes. Incomplete rinsing after the stannous chloride solution treatment leads to loosely adhering precipitate particles forming in the palladium chloride seeder and in the electroless plating solutions and to the rapid decomposition of these solutions.

US—A—4 428 986 discloses a method for direct autocatalytic plating of a metal film on beryllia. The method comprises roughening the surface of the beryllia by immersing in a 50 percent sodium hydroxide solution at 250°C for 7 to 20 minutes, rinsing with water, etching the beryllia substrate with fluoroboric acid for 5 minutes, rinsing with water, immersing it in a solution of 5 g/l stannous chloride and 3 N hydrochloric acid, rinsing with water, treating the beryllia surface with a 0,1 g/l palladium chloride solution, rinsing with water, and then electrolessly plating nickel on the beryllia. In the etching step, silica and magnesium are removed from the grain boundaries of the beryllia thereby weakening the beryllia surface. As a result, the method of US—A—4 428 986 was able to achieve only 1,7 MPascal bond strength before the beryllia substrate broke. This bond strength is too low for practical use being approximately one third of the bond strength normal in thick film type circuits.

The prior art processes described are unreliable as they result in incomplete surface coverage with or unacceptably low bond strength of the formed metal deposits, or both, and are, therefore, completely unsatisfactory for production purposes.

Other suggested methods of forming printed circuit patterns on ceramic substrates are disclosed in the following US—A—3 772 056, 3 772 078, 3 907 621, 3 925 578, 3 930 963, 3 959 547, 3 993 802 and 3 994 727 further indicating the strong and since considerable time existing interest in such circuits.

None of the prior art teachings discloses, however, how to solve the problem of poor surface coverage and inadequate bond strength between metal deposit and ceramic surface.

Ceramic packages have been widely used, e.g., to protect microelectronic circuits such as integrated and hybrid circuits from contamination by the outside environment. A hermetic seal is required between the ceramic base of the package and its cover to exclude the outside environment.

Heretofore, hermetic seals have been provided by the following methods for ceramic dual-in-line packages utilized in the microelectronics industry.

In one method, a refractory metal paste, usually comprising a molybdenum-manganese alloy, is applied to a ceramic base.

The paste and the ceramic base are fired at 1 500—1 800°C in an inert or a reducing atmosphere in order to fuse the molybdenum-manganese alloy to the ceramic surface. The refractory metal alloy is then plated with gold or with nickel and gold. A microelectronic circuit is inserted within a cavity of the ceramic base through an opening in said base.

The microelectronic circuit is connected to feed throughs provided in the base. The opening in the ceramic base is hermetically sealed by covering it with a cover which is soldered in place around the periphery of the opening. Gold plated Kovar lids or ceramic lids provided with gold plated molybdenum-manganese surfaces are used as covers. Soldering takes place in a nitrogen atmosphere using gold-tin solders or tin-silver-antimony solders.

This process, while capable of producing good hermetic seals, is characterized by very high cost because of the difficulties related to the very high firing temperatures.

Epoxy adhesives also have been used to provide seals between a ceramic package and a lid. This method is unsatisfactory because organic vapors from the epoxy sealant may contaminate the microelectronic circuit.

Still another method of forming hermetic seals for a ceramic package is to use a low melting glass which is applied as a glass paste with a carrier solvent and then fused in a furnace. This method is unsatisfactory because it may seal solvents from the glass paste into the package along with some of the glass itself. Reliability of the circuit can be destroyed by contamination due to the solvent trapped in the glass interlayer.

It is the object of the present invention to avoid the above described problems of the prior art and to provide a method of applying a metal film or layer to a ceramic substrate and obtaining substantially complete surface coverage and a bond strength between metal layer and ceramic of at least 3 MPa, and preferably not less than 5 MPa.

A further object of the invention is to provide an electrolessly deposited, direct bonded conductor pattern having excellent adhesion to a ceramic substrate and a process for producing the metal coated ceramic substrate.

Another object of the invention is to produce a metal plated ceramic substrate which may be used for fine line printed circuit pattern applications with highly pure metal conductors.

Another object of the invention is to provide a ceramic substrate with conductors suitable for interconnection in high speed logic circuits and a process for producing the same.

A further object of the invention is to provide a ceramic substrate with a conductor pattern on both sides and at least one through hole connection having a metallized wall and a conductor density comparable to at least a three or four layer thick film multilayer ceramic.

It is also an object of the invention to provide a method of joining metallized ceramics by soldering, brazing or welding or other known methods and to provide a hermetic seal.

Additional objects and advantages of the invention will be set forth in the description.

The present invention is directed to a method of producing metal films or layers on ceramic substrates including alumina which provide substantially complete surface coverage and excellent bond strength between metal deposit and ceramic, i.e., at least 3 MPa, preferably in excess of 5 MPa, as measured by the "dot pull test" described hereinbelow. It also includes ceramic substrates having printed circuit patterns formed from such films or metal layers. The process of this invention may be used to treat ceramic substrates for electroless or electrolytic metal deposition.

Metal deposits on the ceramic substrate or article are obtained having a thickness of at least 0,2 µm, preferably at least 2 µm, and conductor features typically with a width of 25 µm, preferably 50 µm.

In another embodiment, the process of this invention also includes joining the metallized ceramic substrate to a metal or to another metallized ceramic substrate by soldering, brazing or welding.

In accordance with the present invention, there is claimed a method for partially or completely coating a ceramic article or substrate with a metal layer directly and securely bonded to the said substrate comprising at least the following steps: (a) treating the substrate surface with a melt comprising one or more alkali metal compound(s), and rinsing the substrate, neutralizing and rinsing again; and (b) exposing said surface to a solution having an acidity of at least 0,001 molar in hydrogen ions (pH≦3) and comprising one or more halides selected from chlorides, bromides and iodides in an amount greater than 1,2 moles halide per liter and sufficient to promote uniform and secure adsorption of species rendering said surface receptive for metal deposition, said solution being used in a pre-treatment step prior to, or constituting part of the solution(s) employed in the process sequence for rendering said surface receptive for metal deposition; and (c) exposing the thus treated surface or selected parts thereof to a metal plating bath solution for depositing the desired metal on said surface thus forming a substantially completely uniform, defect-free deposit free of bare spots and securely bonded to the ceramic substrate or article.

In accordance with the present invention, any platable metal may be deposited on the surface of a ceramic substrate or article. Typically, copper, nickel, silver or cobalt metal films may be electrolessly deposited.

Many alkali metal compounds have been found to be sutiable for adhesion promotion, e.g., etching of ceramics. Preferred alkali metal compounds include sodium hydroxide, potassium hydroxide, sodium carbonate and potassium nitrate, and potassium hydrogen sulfate.

It is preferred to use compounds with lower melting points. Alternatively, the melting points of the alkali metal compound(s) may be depressed by dissolving up to about 50% by weight, preferably up to 20% by weight, of low melting materials or even liquids in the alkali metal compound(s).

Examples of such melting point depressants are believed to include stannous chloride, nitric acid, water, sodium and potassium formates, potassium acetate, Rochelle salts, borax, and the hydrates of lithium bromide, iodide and phosphate, and potassium pyrophosphate.

Sometimes, it may be preferable to avoid hydroxides for safety reasons and for ease of neutralization. Typical alkali metal compounds suitable for use in the invention and their melting points as reported in Lange's Handbook of Chemistry, 11th Edition (1972) are as follows:

| | | Melting point °C | | |
| Alkali metal | Hydroxide | Nitrate | Carbonate | Hydrogen sulfate |
|---|---|---|---|---|
| Lithium | 445 | 261 | 618 | 171 |
| Sodium | 328 | 308 | 851 | 315 |
| Potassium | 360 | 334 | 891 | 214 |
| Rubidium | 300 | 310 | 837 | — |
| Cesium | 272 | 414 | — | — |

Eutectic mixtures such as a mixture of potassium hydroxide and sodium hydroxide or a mixture of sodium carbonate and potassium nitrate also may be used to etch the substrate. The former type of mixture preferably has a percent by weight ratio of 59:41 of KOH to NaOH with a melting point of 170°C.

Typical of the ceramic substrates etched by the molten compounds employed herein are aluminas, silicates, beryllias, titanates, forsterite, mullite, steatite, porcelains and mixtures of the foregoing.

Typical of the metal deposition solutions used are electroless plating solutions for nickel, cobalt, gold and copper. Electrolytic deposition solutions also may be used in the practice of this invention.

Applicants have discovered that adsorption of the species rendering the thus prepared ceramic surface receptive to metal deposition, and eventually surface coverage of the metal deposit formed on it, is greatly enhanced by treatment of the etched surface with a compound that is adsorbed on such ceramic surface and promotes substantially uniform adsorption of said species, e.g., the sensitizing seeding or catalyzing species over the whole surface, and surprisingly, provides complete defect-free metal coverage.

Among the compounds that can be adsorbed and promote adsorption of said species are simple chlorides, bromides and iodides, and complexes of chlorides, bromides and iodides in acidic solution having a halide concentration greater than 1,2 molar. These acidic halide solutions do not attack the glassy phase of the ceramic substrate.

The acidic chloride, bromide or iodide solution can be used as a pretreatment solution for the ceramic substrate after adhesion promotion, rinsing, neutralizing and rinsing again, and before treating with, e.g., stannous chloride sensitizer. It has been found, that after such pretreatment, sensitizer is quickly adsorbed on the etched ceramic substrate.

Immersion in the sensitizing solution need not be unduly prolonged. In addition, the tin species is so securely adsorbed that it is not inadvertently removed in a conventional rinsing step.

The concentration of the acidic chloride, bromide or iodide pretreatment solution is greater than 1,2 molar, preferably greater than 2 molar, and more preferably greater than 3 molar in halide ion. The acidity of the halide solution is greater than 0,001 molar, preferably greater than 0,01 molar and more preferably between 0,1 and 12 molar in hydrogen ion.

Alternatively, applicants have found that the chloride, bromide or iodide and hydrogen ion concentration of the solution(s) employed for rendering the ceramic surface receptive for metal deposition may be increased to accomplish the same desired effect. Too high an acidity, however, inhibits adsorption of tin comprising sensitizers. The ratio of the halide to acid in a stannous ion sensitizer solution is preferably at least 15:1. It is possible to use halide to acid ratios as low as 2:1 but these are not preferred because higher tin concentrations, i.e., 1 molar tin, are required.

Although it is not intended to be bound by theory, it is believed that in case of tin comprising solutions, the tin species adsorbed on the alumina is the tetrahalostannate (II) moiety. For example, high chloride ion concentration relative to acidity favors the formation of tetrachlorostannate(II), while high acid concentration favors the formation of trichloro- and dichloro-stannate(II) complexes. See for example Stability Constants of Metal Ion Complexes, Spec. Publ. 17, Sillen & Martell, The Chemical Society, London (1964), pp. 296—297.

Unitary catalyst solutions prepared from both stannous chloride and palladium chloride, well known in the printed circuit and plating-on-plastic arts, may also be used. Typical catalyst solutions are found in US patents 4 187 198 and 3 961 109.

When using a unitary catalyst solution comprising a chloride, bromide or iodide of palladium, a tin halide and the halide acid or alkali metal halide salt without an acidic halide predip solution, the halide concentration in said catalyst may be varied over a range from 1,2 to 6 moles per liter, preferably greater than 1,5 moles per liter and preferably less than 4 moles per liter. The acidity may be varied from 0,03 to 6 moles per liter, preferably greater than 0,3 moles and less than 4 moles per liter.

For greater processing latitude and to minimize processing errors, the acidic halide pretreatments may be combined with a sensitizer solution formulated with the halide and acid concentrations according to this invention.

Furthermore, the acidic halide predip also may be used with a unitary catalyst solution.

By using an acidic halide predip, other precious or semi-precious metals or metal compounds suitable for rendering the surface receptive to metal deposition may be adsorbed onto the ceramic surface amongst which are the Group VA metals, silver, gold, and the other Group VIII precious metals.

Numerous processes are employed in the manufacture of printed circuit boards. As will be understood by those skilled in the art, these printed circuit manufacturing processes may be used in conjunction with the present invention for reliably and efficiently producing metal coated ceramic substrates suitable for the manufacture of printed circuits or for directly producing such circuit conductor networks on ceramic substrates.

According to the invention, there are also produced articles and methods which provide a hermetic seal of a metal layer to a ceramic substrate and hermetically sealed ceramic packages for microcircuits and other applications. Furthermore, the processes of this invention provide a method of applying an adherent metal film to a ceramic surface, which film can be used to join metallized ceramic surfaces or to join metallized ceramic surfaces to metal articles by standard metal joining techniques such as soldering, brazing or welding.

By "hermetic seal", as used throughout this specification, is meant one which passes the fine leak tests of MIL-STD-883B, Method 1014.3 (May 16, 1979).

Other modes of operation of the invention are, inter alia, disclosed in the examples.

Example I

This example shows how a chloride or bromide containing predip of this invention causes uniform surface coverage. Flat black ceramic substrates, 0,5 mm thick, containing 50% alumina (balance other oxides) were first cleaned by immersion in an alkaline cleaning solution (Altrex$^{RTM}$) for 10 minutes at a temperature of 60°C and water rinsed for 1 minute at 25°C. Subsequently, the substrates were dipped in a solution of sodium hydroxide (760 g/l), removed and allowed to drain. The resulting wet ceramic substrates were placed on edge in a support fixture, dried for 10 minutes at 175°C and heated in a furnace for 15 minutes at 450°C to melt and fuse the sodium hydroxide and roughen and thus providing the surface with the desired texture. After cooling for 5 minutes, the ceramic substrates were rinsed in water and in 20% sulfuric acid at 25°C for 2 minutes, and subsequently in deionized water for 2 minutes at 25°C. After this procedure, the ceramic substrates were electrolessly plated with an adherent copper film by the following process:

(a) Immerse in a chloride or bromide predip solution as shown in Table 1 for 2 minutes at room temperature.

(b) Immerse for 10 minutes at room temperature in a sensitizer solution consisting of 59 g of stannous chloride dissolved in 1 liter of 0,12 molar hydrochloric acid solution.

(c) Rinse in deionized water at room temperature.

(d) Immerse for 2 minutes at room temperature in an activator solution of 0,1 g palladium chloride dissolved in 1 liter of 0,012 molar hydrochloric acid.

(e) Plate for 30 minutes at room temperature in an electroless copper plating solution consisting of:

| | | |
|---|---|---|
| Copper sulfate | | 10 g/l |
| Ethylenediaminetetra-2-hydroxypropanol | | 17 g/l |
| Formaldehyde | | 6 g/l |
| Block copolymer wetting agent | | 10 mg/l |
| Sodium cyanide | | 10 mg/l |
| Sodium hydroxide | to pH | 13 |

The effects of the different halide predip solutions on the surface coverage of the ceramic substrate are shown in Table 1.

TABLE 1

| Halide predip solution | Surface coverage with metal |
|---|---|
| 1. None (control) | Unacceptable—some bare spots |
| 2. 1,2 M HCl (control) | Unacceptable—some bare spots |
| 3. 1,0 M NaCl (control) pH<1 | Unacceptable—some bare spots |
| 4. 4,0 M HCl | Complete metal film |
| 5. 6,0 M HCl | Complete metal film |
| 6. 9,0 M HCl | Complete metal film |
| 7. 12 M HCl pH<1 | Complete metal film |
| 8. 3,4 M NaCl pH<1 | Good—complete metal film |
| 9. 5,0 M NaBr pH<1 | Good—complete metal film |
| 10. 3,8 M NaCl<br>0,1 M HCl<br>0,25 M SnCl$_2$ | Good—complete metal film |

Unacceptable coverage means a copper deposit with good color and adhesion but some skip plating or bare spots. Complete metal film means a copper deposit of good color and adhesion and complete coverage without bare spots or skip plating.

Example II

This example shows the effect of the pH of the halide predip solution.

The procedures of Example I were repeated except that the halide predip solutions used and the results obtained were as shown in Table 2.

TABLE 2

| Halide predip solution | Surface coverage with metal |
|---|---|
| 1. 3,8 M NaCl pH<1 | Good—complete metal film |
| 2. 3,8 M NaCl pH=5<br>(Control) | Unacceptable—some bare spots |
| 3. 3,8 M NaCl pH=8<br>(Control) | Unacceptable—less than 75% coverage |

Example III

The procedure of Example I was repeated except that the halide predip was eliminated, and the sensitizer solution in step (d) modified in accordance with the present invention by the addition of sodium chloride. The sensitizer solution was:

| | |
|---|---|
| stannous chloride | 50 g/l |
| hydrochloric acid | 8 ml/l |
| sodium chloride | 180 g/l |
| halide conc. | 3,66 M |
| pH | 1,1 |

After plating the ceramic substrate in the electroless Cu plating bath of Example I, it had a complete copper film over the ceramic substrate which was free of voids or other defects. Thus, by increasing chloride concentration in the sensitizer solution, complete coverage of the ceramic substrate with a copper film is achieved without the need for a separate halide predip solution step.

## EP 0 128 476 B1

Example IV

This example further illustrates the importance of the halide and hydrogen ion concentrations in the respective process step of the present invention.

The ceramic substrates were cleaned and melt treated as in Example I. A catalyst concentrate was prepared in accordance to the procedure disclosed in US 3 961 109: an aqueous solution comprising palladium chloride, stannous chloride, sodium chloride, hydrochloric acid and resorcinol was prepared and heated. After cooling, the solution was diluted with additional sodium chloride, stannous chloride and hydrochloric acid to obtain a standard concentrate catalyst solution. 31 ml of this concentrate were diluted to 1 liter to obtain the working catalyst solutions. For No. 1 catalyst solution, the 31 ml of concentrate were diluted with a solution of 3,8 molar sodium chloride, 0,11 molar hydrochloric acid and 0,025 molar stannous chloride. No. 2 and No. 3 catalyst solutions were prepared by diluting 31 ml of the concentrate with a 0,36 molar hydrochloric acid solution, 1 molar in sodium chloride (2); and with 0,36 molar hydrochloric acid solution (3), respectively. For catalyst solution No. 4, the 31 ml of concentrate were diluted with a 0,18 molar solution of sulfuric acid. These four catalyst solutions had the compositions shown below:

| Catalyst solution No. | 1 | 2 | 3 | 4 |
|---|---|---|---|---|
| Halides (molar) | 4,23 | 1,58 | 0,59 | 0,28 |
| Hydrogen ion (molar) | 0,1262 | 0,321 | 0,321 | 0,2001 |
| (pH | 0,9 | 0,5 | 0,5 | 0,7) |
| Palladium (g/l) | 0,15 | 0,15 | 0,15 | 0,15 |
| Stannous chloride (g/l) | 23 | 18 | 18 | 18 |
| Sodium chloride (g/l) | 226 | 63,8 | 5,6 | 5,6 |
| Hydrogen chloride (g/l) | 4,6 | 11,7 | 11,7 | 0,6 |
| Resorcinol (g/l) | 1,2 | 1,2 | 1,2 | 1,2 |
| Sulfuric acid (g/l) | 0 | 0 | 0 | 18 |
| Total chloride | 150 | 56 | 21 | 10 |

The etched ceramic substrates were metallized by the following process:
1. Immerse the substrates in one of the catalyst solutions 1 to 4 for 5 minutes at room temperature.
2. Rinse in deionized water.
3. Immerse in an accelerator solution comprising 3% fluoroboric acid in water.
4. Rinse in deionized water.
5. Electrolessly plate copper using the solution of Example I.

The substrates treated with the catalyst solutions No. 1 or No. 2 comprising 150 and 56 g/l chloride, respectively, were found to be completely covered with a uniform and defect-free metal layer while the ceramic substrates treated with the solutions Nos. 3 and 4, low in halide concentration, displayed skip plating, i.e., small areas of the ceramic without copper deposits.

Example V

Adhesion of metal to the ceramic substrate was tested by the "dot pull test".

Instead of plating the substrates in the room temperature electroless copper plating solution of Example I, the substrates were plated in an electroless copper plating solution of the following composition for 2-1/2 hours to deposit a copper layer of 10 μm:

8

| Ethylenedinitrilotetra-2-propanol | | 18 g/l |
| Copper sulfate pentahydrate | | 10 g/l |
| Formaldehyde | | 1,6 g/l |
| Wetting agent* | | 0,01 g/l |
| Sodium cyanide | | 25 mg/l |
| 2-Mercaptobenzothiazole | | 0,01 mg/l |
| Sodium hydroxide | to pH | 12,8 |
| Temperature | | 52°C |

*Nonyl phenoxy polyglycidol phosphate ester (GAFAC^RTM^RE610).

The ceramic substrates were cleaned and treated with the melt comprising the alkali metal compound as described in Example I and metallized by the following process:

1. Immerse for 2 minutes in a room temperature aqueous halide predip solution of 3,8 moles sodium chloride, 0,1 moles hydrochloric acid and 0,025 moles stannous chloride per liter.
2. Immerse at room temperature for 15 minutes in the high chloride catalyst solution (No. 1) of Example IV.
3. Rinse in deionized water.
4. Immerse in the accelerator solution of Example IV.
5. Rinse in deionized water.
6. Plate in the electroless copper deposition solution described above.
7. Rinse and dry.

The substrates were then imaged and etched by conventional photolithographic techniques thus producing copper dots 2,5 mm in diameter. Wires were attached to the copper dots with solder and an average bond strength of 10,8 MPa was measured as the dots were pulled away from the ceramic surfaces.

Example VI

Ceramic substrates, cleaned and alkaline metal compound treated as per Example I, were immersed for 10 minutes in a 3 M hydrochloric acid solution, rinsed in deionized water for 1 minute, immersed in a 0,1 M silver nitrate solution, rinsed in deionized water, and immersed for 30 minutes in the electroless metal deposition bath solutions of Example I. The substrate was completely and uniformly covered with an adherent copper metal deposit.

The procedure was repeated except that after immersion in 3 M hydrochloric acid solution and rinsing, the substrate was immersed for 2 minutes in a 0,9 M nitric acid solution prior to immersion in the 0,1 M silver nitrate solution.

When the ceramic substrate was then rinsed and immersed in the electroless copper deposition bath solution, no copper deposit occurred. The nitric acid solution was tested for the presence of chloride by adding silver nitrate dropwise.

A white precipitate formed indicating the presence of chloride removed from the substrate surface. This shows that the presence of the halides on the surface of the ceramic substrate prior to rendering it receptive to metal deposition is an integral step of the present invention; and, furthermore, that the halides present on the ceramic surface can be removed by improper processing.

Example VII

A white ceramic substrate was processed as described in the first paragraph of Example VI. After immersion in the 0,1 M silver nitrate solution, rinsing in deionized water and drying, the ceramic substrate was exposed to light. The surface darkened indicating that the adsorbed silver chloride was reduced to metallic silver sites. Alternately, the silver chloride may be reduced to metal with a reducing agent.

Example VIII

The procedures of Example I were repeated except that white ceramic substrates, 0,4 mm thick, which were 96% alumina, were substituted for the black substrates of 90% alumina. Again, completely defect-free copper deposits were obtained.

Example IX

A white 96% alumina substrate, 30×30 mm and 0,4 mm thick was rinsed and alkaline metal compound treated as per Example I. It was then coated with copper by the following procedure:

1. Immerse for 5 minutes in an aqueous solution containing an amphoteric surfactant (tallow betaine surfactant), a nonionic surfactant (nonylphenoxypolyethoxyethanol) and ethanolamine, the solution adjusted to pH 2.

2. Rinse in water.

3. Immerse for 2 minutes in the halide predip solution of Example V.

4. Immerse for 5 minutes in the catalyst solution of Example V.

5. Rinse in water.

6. Electrolessly deposit copper using the copper plating bath solution of Example I.

A uniform coating of copper was obtained free of voids and skip plating. The copper clad ceramic was coated with a polyvinylcinnamate (KPR™), exposed, and developed with KPR™ developer solution to produce the negative resist image of a chip carrier on the copper clad substrate. The exposed copper surface, corresponding the desired chip carrier pattern, was electroplated in a copper plating solution (Copper Gleam PC™) to a copper thickness of 0,01 mm. The resist was then removed with solvents, and the electroless copper deposit, outside the chip carrier image pattern, removed by immersion in a solution of sodium persulfate, thus producing a finished chip carrier with 132 conductors on 0,14 mm pitch fanning out to 0,36 mm pitch.

Example X

The procedure of Example IX was repeated on both 90% and 96% alumina substrates, 0,4 mm thick and measuring 75×75 mm. Instead of a chip carrier conductor pattern, eight copies of a copper conductor pattern for a hybrid circuit A/D (analog to digital) converter were produced on each substrate. The hybrid circuit conductor patterns have 125 µm wide pure copper conductors, input and output connections and all the interconnections for six integrated circuits and associated chip capacitors and resistors. After the circuit patterns were completed by removing the electroless copper deposit in the background, the individual hybrid circuits were cut out of the 75×75 mm wafer using a laser beam.

Example XI

Example X was repeated except that the hybrid circuit conductor patterns were electroplated with nickel and gold over the electroplated copper. This produced a circuit with a clean, smooth, pure gold surface substantially superior for wire bonding over screened gold paste thick film circuits.

Example XII

A 64 pin carrier was produced on an alumina substrate. The substrate was provided with laser drilled holes of 0,4 mm in diameter and the chip carrier was produced by the method of Example IX except that the conductor pattern was produced on both sides with plated through hole wall connections formed simultaneously.

Example XIII

Additive hybrid circuit conductor patterns were produced by first processing ceramic substrates as described in Example V up to and including the catalyzing and rinsing steps. Next, the substrates were dried and a polymeric dry film photo resist (Riston 1401™) applied to the substrates, exposed through a printing master to ultraviolet light, and developed by conventional means to produce the negative image of the hybrid circuit conductor patterns. The substrates were then immersed in the electroless copper plating bath solution of Example V for 2-1/2 hours thus depositing a pure copper conductor pattern 10 µm thick. To complete the circuits, the background resists were removed with a solvent.

Example XIV

The procedure of Example V was repeated except that instead of an etched dot pattern, a hybrid circuit conductor pattern was produced by photolithography.

Example XV

A 96% alumina ceramic substrate was treated as follows:

1. Immerse in an alkaline cleaning solution at 60°C.

2. Rinse in water.

3. Dry in a hot air oven at 160°C.

4. Immerse the substrate in a molten sodium and potassium hydroxide eutectic solution of 205 g sodium hydroxide and 295 g potassium hydroxide at 210°C for 10 minutes.

5. After removing and cooling rinse in water at room temperature for 5 minutes.

6. Treat in 3 M hydrochloric acid solution for 2 minutes.

7. Rinse in deionized water.

The thus adhesion promoted substrate was plated with an adherent copper layer by the procedure of Example IX, steps 1 through 6. A uniform, adherent copper deposit was obtained free of voids, blisters, bubbles and skip plating.

Example XVI

A ceramic substrate, 90% alumina, was treated as follows:

1. Immersing in a hot alkaline cleaning solution.
2. Rinsing in water.
3. Dipping in an aqueous 2,8 M solution of potassium hydrogen sulfate.
4. Dyring in an oven at 160°C.
5. Fusing the potassium hydrogen sulfate on the surface of the substrate at 450°C.
6. Rinsing in water.
7. Immersing in a 10% sulfuric acid solution.
8. Rinsing in water.

The thus prepared substrate was metallized by the process of Example IX, steps 1 through 6. A uniform, adherent copper deposit was obtained free of voids, blisters and skip plating.

Example XVII

Four grams of sodium carbonate were ground together with one gram of potassium nitrate. These dry, mixed powders were poured onto a black ceramic substrate (90% alumina), which was then placed in an oven and heated to 700°C for 20 minutes to fuse the powder. After cooling, the substrate was rinsed with water, immersed in a 10% solution of nitric acid and again water rinsed. The thus prepared substrate was metallized as in Example IX, steps 1 through 6. A uniform, adherent copper deposit was obtained, free of voids, blisters and skip plating.

Example XVIII

A ceramic substrate comprising silicon carbide and beryllia was provided with an adherent hybrid circuit pattern of pure copper conductors by the process of Example XIII. The result was a strongly adherent, defect-free copper circuit pattern on a high beryllia substrate with excellent heat transfer characteristics.

Example XIX

The procedure of Example III was repeated except that an electroless nickel plating bath was substituted for the electroless copper plating bath. After 30 minutes immersion in the electroless nickel plating bath, the ceramic substrate was completely covered with a uniform, adherent nickel deposit 10 μm thick and was free of skip plating and other defects.

Example XX

A ceramic substrate (96% alumina) was cleaned and melt treated by the procedure described in Example I and provided with a conductive border by painting the edges with silver paint. The substrate was immersed for 5 minutes in the aqueous solution of Example IX, step 1, and water rinsed. It was then immersed for 5 minutes in the halide solution of Example V, step 1, subsequently for 10 minutes at 40°C in the catalyst solution of Example V, step 2, water rinsed, dipped for 5 seconds in an aqueous solution of 3,5% fluoroboric acid and 0,4% hydroxyethylethylenedinitrilotriacetic acid, electroplated with copper in an aqueous solution comprised of 75 g/l copper sulfate, 190 g/l sulfuric acid, 50 mg/l chloride ion and 1 g/l Pluronic$^{RTM}$ F-127 (a block copolymer of polyoxyethylene) and polyoxypropylene) at a current density of 0,35 mA/mm². The thus formed copper deposit was found to be free of defects and securely bonded to the substrate surface.

Example XXI

A ceramic lid made to fit over the opening in a hybrid circuit package was cleaned and treated with the alkaline metal compound melt as described in Example I and then metallized by the following procedure.

1. Immerse for 2 minutes in a room temperature aqueous chloride solution of 3,8 moles sodium chloride, 0,1 moles by hydrochloric acid and 0,025 moles stannous chloride per liter.
2. Immerse for 15 minutes in the high chloride catalyst solution (No. 1) of Example IV.
3. Rinse in water.
4. Immerse in the accelerator solution of Example IV.
5. Rinse in water.
6. Plate with copper using the electroless copper deposition solution of Example V.
7. Rinse and dry.

The metallized ceramic lid was electroplated with a tin-lead eutectic alloy solder layer from a conventional tin-lead fluoroborate electroplating solution and the solder deposit reflowed with heat. The thus prepared ceramic lid was positioned on top of the opening in the hybrid circuit package to close said package. The periphery of the opening in the hybrid circuit package was also provided with a metallized layer covered with solder. A force was then applied with a weight on the top of the lid. The metallic ceramic lid was hermetically sealed to the hybrid circuit package by passing the package and lid, under nitrogen atmosphere, through a belt furnace maintained at 20°C above the eutectic melting point of the solder alloy. The thus prepared assembly was cooled to room temperature and the weight removed.

The seal of the hybrid circuit package to the lid was tested and was found to be a hermetic seal as defined by MILSTD.883.

**Claims**

1. A method for partially or completely coating a ceramic article or substrate with a metal layer directly and securely bonded to the said article or substrate, comprising at least the following steps:

   (a) treating the substrate surface with a melt comprising one or more alkali metal compound(s), and rinsing the substrate, neutralizing and rinsing again; and

   (b) exposing said surface to a solution having an acidity of at least 0,001 molar in hydrogen ions (pH≦3) and comprising one or more halides selected from chlorides, bromides and iodides in an amount greater than 1,2 moles halide per liter and sufficient to promote uniform and secure adsorption of species rendering said surface receptive for metal deposition, said solution being used in a pre-treatment step prior to, or constituting part of the solution(s) employed in the process sequence for rendering said surface receptive for metal deposition; and

   (c) exposing the thus treated surface or selected parts thereof to a metal plating bath solution for depositing the desired metal on said surface thus forming a substantially completely uniform, defect-free deposit free of bare spots and securely bonded to the ceramic substrate or article.

2. The method of claim 1 wherein the substrate is completely coated with the metal deposit and portions of said deposit are removed in a later step thus forming the conductors of a printed circuit pattern.

3. The method of claim 2 wherein the metal deposit is first provided with a masking layer corresponding the desired conductor pattern and the exposed metal is subsequently removed by etching.

4. The method of claim 1 wherein the surface of the ceramic substrate or article is selectively rendered receptive to metal deposition in the area corresponding a printed circuit conductor pattern to be formed.

5. The method of claim 1 wherein the entire surface is rendered receptive for metal deposition and subsequently provided with a masking layer corresponding the negative of a desired printed circuit conductor pattern.

6. The method of claims 1 to 5 wherein the substrate is provided with at least one hole having metallized walls.

7. The method of claims 1 to 6 wherein the substrate is transferred without rinsing from the pre-treatment halide solution to the solution, or the first solution of a sequence, for rendering its surface receptive to metal deposition.

8. The method of claims 1 to 7 wherein the alkali metal compound is selected from hydroxides, carbonates, nitrates, hydrogen sulfates and mixtures thereof.

9. The method of claim 8 wherein said mixture is an eutectic mixture.

10. The method of claim 8 or 9 wherein said melt further comprises one or more compounds which depress the melting point.

11. The method of claim 10 wherein said further compound(s) is (are) present in an amount of 20% by weight or more.

12. The method of claims 1 to 11 wherein the acidic halide solution is selected from hydrochloric acid, hydrobromic acid and acidic alkali metal halide solutions, said alkali metal being selected from sodium and potassium, and said halide from chloride, bromide and iodide.

13. The method of claim 1 wherein said acidic halide solution further comprises stannous chloride.

14. The method of claim 1 wherein said acidic halide solution further comprises an admixture resulting from reacting tin(II)chloride and a precious metal halide.

15. The method of claim 1 wherein subsequent to treating the surface with the acidic halide solution it is further treated with a silver nitrate solution to render it receptive to the deposition of metal.

16. The method of claim 15 wherein the formed silver halide is reduced to metal by exposure to light or a reducing agent.

17. The method of claim 1 wherein the metallized ceramic substrate or article is metallurgically joined to a metal surface or a second metallized ceramic by welding, brazing or soldering thus forming a hermetic seal.

**Patentansprüche**

1. Verfahren zum teilweisen oder vollständigen Beschichten eines keramischen Gegenstandes oder Substrats mit einer auf dem genannten Gegenstand oder Substrat festhaftenden und direkt an diese gebundenen Metallschicht, gekennzeichnet durch die folgenden Verfahrensschritte:

   (a) Behandeln der Substratoberfläche mit einer Schmelze aus einer oder mehreren Alkalimetall-Verbindung(en), gefolgt von einem Spül-, einem Neutralisierungs- und erneuten Spülschritt;

   (b) Behandeln der genannten Oberfläche mit einer Lösung, deren Säuregehalt mindestens einer Wasserstoffionen-Konzentration von 0,001 mol (pH≦3) entspricht, und die ein oder mehrere Halogenid(e), ausgewählt aus den Gruppen Chlor, Brom und Jod, in einer Konzentration von mindestens 1,2 Mol/l enthält, ausreichend, um eine gleichmäßige und sichere Adsorption von auf die Metallabscheidung katakytisch wirkenden Keimen in der genannten Oberfläche zu erzielen, wobei die genannte Lösung entweder in einem Vorbehandlungsschritt vor oder als Teil der Lösung oder Lösungen zur Katalysierung der genannten Oberfläche für die Metallabscheidung verwendet wird; und

   (c) Tauchen der so vorbehandelten Oberfläche als Ganzes oder bestimmter Bezirke in eine

12

Metallisierungsbadlösung zum Abscheiden der gewünschten Metallschicht auf der Oberfläche und Herstellen einer im wesentlichen vollkommen gleichmäßigen, von Fehlstellen freien und fest auf dem keramischen Gegenstand oder Substrat verankerten und direkt an diese gebundenen Schicht des gewünschten Metalls.

2. Verfahren nach Anspruch 1, dadurch gekennzeichnet, daß das Substrat vollständig mit der gewünschten Metallschicht bedeckt wird und in einem späteren Verfahrensschritt Teile der genannten Metallschicht entfernt und so ein Schaltungsmuster hergestellt wird.

3. Verfahren nach Anspruch 2, dadurch gekennzeichnet, daß die Metallschicht zunächst mit eine dem gewünschten Schaltungsmuster entsprechenden Abdeckmaske versehen wird und nachfolgend das freiliegende Metall durch Ätzen entfernt wird.

4. Verfahren nach Anspruch 1, dadurch gekennzeichnet, daß die Oberfläche des keramischen Gegenstandes oder Substrats nur in bestimmten, dem gewünschten Schaltungsmuster entsprechenden Bezirken für die Abscheidung aus Metallplattierungs-Badlösungen katalysiert wird.

5. Verfahren nach Anspruch 1, dadurch gekennzeichnet, daß die gesamte Oberfläche für die Metallabscheidung katalysiert und nachfolgend eine Negativmaske des gewünschten Schaltungsmusters aufgebracht wird.

6. Verfahren nach den Ansprüchen 1 bis 5, dadurch gekennzeichnet, daß das Substrat mindestens ein Loch mit metallisierten Wandungen aufweist.

7. Verfahren nach den Ansprüchen 1 bis 6, dadurch gekennzeichnet, daß das Substrat ohne Zwischenschalten eines Spülschritts nach der Vorbehandlung mit der Halogenid-Lösung in eine bzw. in die erste von mehreren Lösungen zum Katalysieren der Oberfläche für die Metallabscheidung gebracht wird.

8. Verfahren nach den Ansprüchen 1 bis 7, dadurch gekennzeichnet, daß die Alkalimetall-Verbindung aus Hydroxiden, Carbonaten, Nitraten, Wasserstoffsulfaten und Mischungen derselben ausgewählt wird.

9. Verfahren nach Anspruch 8, dadurch gekennzeichnet, daß die genannte Mischung eutektisch ist.

10. Verfahren nach den Ansprüchen 8 oder 9, dadurch gekennzeichnet, daß die Schmelze weiterhin einen oder mehrere Verbindungen zum Niedrighalten des Schmelzpunktes enthält.

11. Verfahren nach Anspruch 10, dadurch gekennzeichnet, daß die genannte(n) weitere(n) Verbundung(en) in einer Menge von 20 Gew.% oder mehr in der Schmelze vorhanden sind.

12. Verfahren nach den Ansprüchen 1 bis 11, dadurch gekennzeichnet, daß die saure Halogenid-Lösung aus den Gruppen von Chlorwasserstoffsäure-, Bromwasserstoffsäure- sowie sauren Alkalimetallhalogenid - Lösungen ausgewählt ist, wobei das Alkalimetall Natrium oder Kalium und das Halogenid Chlorid, Bromid oder Jodid ist.

13. Verfahren nach Anspruch 1, dadurch gekennzeichnet, daß die saure Halogenid-Lösung weiterhin Zinn(II)chlorid enthält.

14. Verfahren nach Anspruch 1, dadurch gekennzeichnet, daß die saure Halogenid-Lösung weiterhin eine Zumischung aus der Reaktion von Zinn(II)chlorid mit einem Edelmetallhalogenid enthält.

15. Verfahren nach Anspruch 1, dadurch gekennzeichnet, daß die Oberfläche nach der Behandlung mit der sauren Halogenid-Lösung in eine Silbernitrat-Lösung gebracht wird, um sie für die Metallabscheidung zu katalysieren.

16. Verfahren nach Anspruch 15, dadurch gekennzeichnet, daß das gebildete Silbernitrat durch Einwirken von Licht oder durch ein Reduktionsmittel reduziert wird.

17. Verfharen nach Anspruch 1, dadurch gekennzeichnet, daß der metallisierte keramische Gegenstand oder das Substrat metallurgisch mit einer Metallschicht oder einem zweiten, metallisierten keramischen Gegenstand oder Substrat durch Löten, Hartlöten oder Schweißen verbunden wird und so eine hermetische Versiegelung hergestellt wird.

**Revendications**

1. Procédé pour appliquer partiellement ou complètement un revêtement sur un article ou un substrat en céramique d'une couche métallique liée directement et solidement à l'article ou au substrat, comprenant au moins les étapes suivantes consistant à:

(a) traiter la surface du substrat avec une masse fondue comprenant un ou plusieurs composés de métaux alcalins, et rincer le substrat, le neutraliser et le rincer de nouveau; et

(b) exposer la surface à une solution ayant une acidité d'au moins 0,001 mole dans des ions hydrogène (pH≤3) et comprenant un ou plusieurs halogénures choisis parmi les chlorures, bromures et iodures dans une quantité supérieure à 1,2 mole d'halogénure par litre et suffisante pour stimuler l'adsorption uniforme et sûre d'espèces rendant la surface réceptrice à un dépôt métallique, la solution étant utilisée dans une étape de pré-traitement avant, ou constituant une partie de la (des) solution(s) employée(s) dans la séquence du procédé pour rendre la surface réceptric eà un dépôt métallique, et

(c) exposer la surface ainsi traitée ou des parties sélectionnées de celle-ci à une solution d'un bain de revêtement métallique pour déposer le métal désiré sur la surface, formant ainsi un dépôt sensiblement complètement uniforme exempt de défauts, ne présentant pas des points mis à nu et liés de façon sûre au substrat au article en céramique.

2. Procédé selon la revendication 1, dans lequel le substrat est complètement revêtu du dépôt

13

métallique et des parties du dépôt sont enlevées dans une étape ultérieure, formant ainsi les conducteurs d'un motif de circuits imprimés.

3. Procédé selon la revendication 2, dans lequel le dépôt métallique est tout d'abord effectué avec une couche de masquage correspondant au motif désiré pour les conducteurs et le métal exposé est ensuite enlevé par gravure.

4. Procédé selon la revendication 1, dans lequel la surface du substrat ou article en céramique est sélectivement rendue réceptric eau dépôt métallique dans la zone correspondant à un motif de conducteurs de circuits imprimés devant être formé.

5. Procédé selon la revendication 1, dans lequel la surface entière est rendue réceptrice à un dépôt métallique et ensuite munie d'une couche de masquage correspondant au négatif d'un motif désiré pour les conducteurs de circuits imprimés.

6. Procédé selon les revendications 1 à 5, dans lequel le substrat comporte au moins un trou ayant des parois métallisées.

7. Procédé selon les revendications 1 à 6, dans lequel le substrat est transféré sans rinçage de la solution d'halogénure de pré-traitement à la solution, ou première solution d'une séquence, pour rendre sa surface réceptrice à un dépôt métallique.

8. Procédé selon la revendication 1 à 7, dans lequel le composé de métal alcalin est choisi parmi les hydroxydes, carbonates, nitrates, sulfates acides et leurs mélanges.

9. Procédé selon la revendication 8, dans lequel le mélange est un mélange eutectique.

10. Procédé selon la revendication 8 ou la revendication 9, dans lequel la masse fondue comprend en outre un ou plusieurs composés qui abaissent le point de fusion.

11. Procédé selon la revendication 10, dans lequel le ou les autres composés sont présents suivant une quantité de 20% en poids ou plus.

12. Procédé selon les revendications 1 à 11, dans lequel la solution d'halogénure acide est choisie parmi l'acide chlorhydrique, l'acide bromhydrique et des solutions d'halogénure de métal alcalin acide, le métal alcalin étant choisi parmi le sodium et le potassium, et l'halogénure parmi un chlorure, un bromure et un iodure.

13. Procédé selon la revendication 1, dans lequel la solution d'halogénure acide comprend en outre du chlorure stanneux.

14. Procédé selon la revendication 1, dans lequel la solution d'halogénure acide comprend en outre un mélange résultant de la réaction du chlorure d'étain (II) et d'un halogénure de métal précieux.

15. Procédé selon la revendication 1, dans lequel à la suite du traitement de surface avec la solution d'halogénure acide, celle-ci est en outre traitée avec une solution de nitrate d'argent pour la rendre réceptrice au dépôt du métal.

16. Procédé selon la revendication 15, dans lequel l'halogénure d'argent formé est réduit en métal par exposition à la lumière ou à un agent de réduction.

17. Procédé selon la revendication 1, dans lequel le substrat ou l'article en céramique métallisé est lié métallurgiquement à une surface métallique ou à une seconde céramique métallisée par soudage, brasage, brasage fort formant ainsi un joint hermétique.